# EUROPÄISCHE PATENTSCHRIFT

(11) **EP 3 867 659 B1**
(45) Veröffentlichungstag und Bekanntmachung des Hinweises auf die Patenterteilung: **19.07.2023**
(21) Anmeldenummer: 19786938.1
(22) Anmeldetag: 09.10.2019
(51) Int. Cl.: G01R 31/72, G01R 31/28, F16K 37/00, H01F 7/18

(54) **VERFAHREN ZUM BESTIMMEN EINES SCHALTZUSTANDS EINES VENTILS UND ELEKTROMAGNETVENTILANORDNUNG**
METHOD FOR DETERMINING A SWITCHING STATE OF A VALVE, AND SOLENOID VALVE ASSEMBLY
PROCÉDÉ POUR DÉTERMINER UN ÉTAT DE COMMUTATION D'UNE VANNE ET SYSTÈME D'ÉLECTROVANNE

(30) Priorität: 15.10.2018 DE 102018217663
(43) Veröffentlichungstag der Anmeldung: 25.08.2021
(73) Patentinhaber: Continental Automotive Technologies GmbH, 30165 Hannover (DE)
(72) Erfinder: MAJ, Bartosz, 60488 Frankfurt/Main (DE); KOLLMANN, Holger, 60488 Frankfurt/Main (DE); MILIC, Tomislav, 60488 Frankfurt/Main (DE); SCHÖNBOHM, Alexander, 60488 Frankfurt/Main (DE); SCHRÖDER, Ralf, 60488 Frankfurt/Main (DE); LENZ, Marc, 60488 Frankfurt/Main (DE); BLETZ, Marcus, 60488 Frankfurt/Main (DE); SCHMIDT, Jurij, 60488 Frankfurt/Main (DE); DINKEL, Dieter, 60488 Frankfurt/Main (DE)
(74) Vertreter: Continental Corporation
(86) Internationale Anmeldenummer: PCT/EP2019/077393
(87) Internationale Veröffentlichungsnummer: WO 2020/078805

(56) Entgegenhaltungen:
- EP-A1- 1 384 976
- DE-A1-102014 216 610
- DE-C1- 19 836 769
- US-A1- 2018 231 143

## Beschreibung

Die Erfindung betrifft ein Verfahren ein Verfahren zum Bestimmen eines Schaltzustands eines Ventils nach Anspruch 1 und eine Elektromagnetventilanordnung nach Anspruch 8.

Ventile können insbesondere mittels Elektromagneten betätigt werden. Hierzu können entsprechende Elektromagnetventilanordnungen aufgebaut werden, welche typischerweise ein Ventil und eine Spule zur Betätigung des Ventils aufweisen.

Gemäß dem Stand der Technik ist es bekannt, Ventile dadurch zu schalten, dass die jeweilige Spule mit einem zum Schalten geeigneten Strom beaufschlagt wird. Ein dadurch erzeugtes Magnetfeld sorgt typischerweise für ein Schalten des Ventils oder hält das Ventil in einem bestimmten Zustand. Allerdings wird bei Ausführungen gemäß dem Stand der Technik typischerweise davon ausgegangen, dass ein eingestellter bzw. gewünschter Schaltzustand auch tatsächlich eingenommen wird. Eine Überprüfung ist nicht vorgesehen.

Aus der EP 1 384 976 A1 ist bekannt, die Position eines Kerns in einer Spule zu bestimmen. Dazu wird nach Anlegen einer Spannung die Stromänderung durch die Spule auf einen bestimmten Stromwert in einer bestimmten Zeitspanne erfasst. Daraufhin wird eine weitere Spannungsänderung vorgenommen und wiederum Stromstärken und Zeitdauern bestimmt, um die Position des Kerns zu ermitteln.

In der US 2018/0231143 A1 wird beschrieben einen Anregungspuls an die Spule anzulegen, welcher klein genug ist die Position des Kerns nicht zu verändern. Darauffolgend werden mehrere Spannungen gemessen, wobei die Spannungen von der Position abhängen.

Aus der DE 198 36 769 C1 ist bekannt, die Position einer Ankerplatte in einer Spule zu bestimmen, indem zeitliche Ableitungen des Stroms durch die Spule und Spannungsabfälle an der Spule an zwei Zeitpunkten bestimmt werden.

Die DE 10 2014 216 610 A1 offenbart eine Überwachung einer Spule, bei der zur Plausibilisierung eines durch die Spule flißenden Stroms ein Widerstand bestimmt wird, basierend auf zwei gemessenen Strömen, deren Zeitabstand und der Induktivität der Spule.

Bekannte stromlos offene Einlassventile sperren bei Bedarf die hydraulische Verbindung zu einem Bremssattel ab, wenn der Systemdruck höher ist als der Druck, der im Bremssattel herrschen soll. Beispielsweise kann dies während einer ABS-Regelung der Fall sein.

Ein Rückschlagventil ist dabei in heutigen Einlassventilen typischerweise dafür zuständig, beim Lösen der Bremse den Druck im Bremssattel sicher abzubauen, beispielsweise im Falle eines klemmenden Ventils.

Jedoch ist dann das Vorsehen weiterer Ventile notwendig, die dafür zuständig sind, den Druck im Rad einzusperren (z.B. beim Nachsaugen eines LAC). Ferner tritt der sog. "Cross-Flow" auf, bei dem...

Es ist deshalb eine Aufgabe der Erfindung, ein Verfahren zum Bestimmen eines Schaltzustands eines Ventils vorzusehen. Es ist des Weiteren eine Aufgabe der Erfindung, eine zugehörige Elektromagnetventilanordnung vorzusehen.

Die Erfindung betrifft ein Verfahren zum Bestimmen eines Schaltzustands eines Ventils, welches mittels einer Spule betätigt wird. Das Verfahren weist folgende Schritte auf:
- zu einer Mehrzahl von Zeitpunkten, welche mit einem vorgegebenen Zeitabstand aufeinander folgen, jeweiliges Ermitteln eines durch die Spule fließenden Stroms und einer an der Spule anliegenden Spannung,
- Berechnen einer Induktivitätsgröße der Spule basierend auf den Strömen, der Spannung und dem Zeitabstand, und
- Bestimmen des Schaltzustands basierend auf der Induktivitätsgröße.

Die Erfindung beruht auf der Erkenntnis, dass durch das Messen der Ströme und Spannungen zu den erwähnten Zeitpunkten eine Induktivitätsgröße ermittelt werden kann, wobei basierend auf dieser ein Schaltzustand des Ventils ermittelt werden kann. Dies erlaubt eine Überwachung des Schaltzustands, also beispielsweise ob das Ventil offen oder geschlossen ist. Aus einer Änderung des Schaltzustands kann auf ein Schalten des Ventils geschlossen werden bzw. es kann ein Schalten des Ventils erkannt werden.

Strom und/oder Spannung können beispielsweise durch Messen ermittelt werden. Hierzu können geeignete Messgeräte verwendet werden. Sie können jedoch jeweils auch durch Wertvorgabe ermittelt werden. Dies kann insbesondere dann der Fall sein, wenn ein Wert vorgegeben und durch ein hierfür geeignetes Gerät eingestellt wird. Beispielsweise kann hierfür eine geregelte Stromquelle verwendet werden, um einen definierten Strom einzustellen. Gleiches gilt für die Spannung. In diesem Fall ist es nicht mehr zwingend notwendig, einen tatsächlich eingestellten Wert zu messen, wobei erwähnt sei, dass trotzdem ein solcher Wert gemessen werden kann.

Als Induktivitätsgröße kann eine Induktivität im physikalischen Sinne verwendet werden. Es kann jedoch auch eine Größe verwendet werden, welche anzeigend ist für die Induktivität, beispielsweise zur tatsächlichen Induktivität proportional ist, jedoch einfacher zu berechnen oder einfacher zu handhaben ist. Typischerweise besteht ein Zusammenhang, beispielsweise ein linearer Zusammenhang, zwischen der Induktivitätsgröße und der tatsächlichen Induktivität.

Es sei angemerkt, dass die Induktivitätsgröße eventuell einfacher zu bestimmen ist als die Induktivität im streng physikalischen Sinn, wobei auch die Induktivitätsgröße oder eine andere einfacher als die Induktivität zu berechnende Größe, welche auf der Induktivität basiert, zur Schaltzustandsbestimmung herangezogen werden kann.

Durch das nicht mehr benötigte Rückschlagventil wird auch eine Einsparung weiterer Ventile zum Einsperren vom Druck im Rad erzielt. Zudem existiert kein "Cross-Flow"-Effekt mehr und es tritt eine Kostenreduzierung durch Wegfall des Rückschlagventils ein.

In einer bevorzugten Weiterbildung des Verfahrens wird aus einer Änderung des Schaltzustands ein Schalten des Ventils erkannt.

In einer bevorzugten Weiterbildung des Verfahrens wird ein Schaltzustand des Ventils durch Erkennen einer Spannungsspitze überwacht. Dies beruht auf der Erkenntnis, dass bei Änderung des Schaltzustands eine Spannungsspitze auftreten kann. Diese kann insbesondere mittels geeigneter Sensorik erkannt werden und entsprechend verwendet werden. Beispielsweise kann diesbezüglich eine Stößelöffnungskontrolle realisiert werden.

Es sei verstanden, dass die Erkennung eines Schaltzustands durch Erkennen einer Spannungsspitze einen eigenständigen Erfindungsaspekt darstellen kann, welcher auch unabhängig von sonstigen hierin offenbarten Merkmalen und Ausführungsformen verwendet werden kann, jedoch auch beliebig mit diesen kombiniert werden kann.

Alternativ oder zusätzlich wird der Schaltzustand eines Ventils aus einem Testsignal erkannt. Dieses kann der Spule aufgeprägt werden, so dass der Schaltzustand erkannt werden kann.

In einer bevorzugten Weiterbildung des Verfahrens wird die Spule mittels Pulsweitenmodulation angesteuert. Bevorzugt werden dabei der Strom und die Spannung jeweils über eine Pulsweitenmodulationsperiode gemittelt. Es hat sich gezeigt, dass in diesem Fall auch bei einer mittels Pulsweitenmodulation angesteuerten Spule eine Anwendung des Verfahrens in vorteilhafter Weise möglich ist.

In einer bevorzugten Weiterbildung der Erfindung wird das Verfahren kontinuierlich oder laufend wiederholt ausgeführt. Damit kann der Zustand eines Ventils kontinuierlich überwacht werden.

In einer bevorzugten Weiterbildung der Erfindung werden folgende Schritte durchgeführt:
- Vergleichen der Induktivitätsgröße mit einem ersten Endwert und einem zweiten Endwert,
- Bestimmen eines ersten Schaltzustandes, wenn die Induktivitätsgröße maximal einen vorbestimmten Abstand vom ersten Endwert hat und
- Bestimmen eines zweiten Schaltzustandes, wenn die Induktivitätsgröße maximal einen vorbestimmten Abstand vom zweiten Endwert hat.

In einer bevorzugten Weiterbildung des Verfahrens sind die Schaltzustände Endzustände des Ventils. Jedoch ist auch die Ermittlung von Zwischenzuständen möglich.

Die Erfindung betrifft weiterhin eine Elektromagnetventilanordnung, aufweisend
- ein Ventil,
- eine Spule zur Betätigung des Ventils,
- eine Steuerungseinrichtung zum Beaufschlagen der Spule mit einem Strom und/oder einer Spannung, und
- einer Zustandsbestimmungseinrichtung, welche dazu konfiguriert ist, ein Verfahren nach einem der vorhergehenden Ansprüche auszuführen.

Die Erfindung betrifft des Weiteren eine Elektromagnetventilanordnung. Diese Elektromagnetventilanordnung weist ein Ventil und eine Spule zur Betätigung des Ventils auf. Sie weist ferner eine Steuerungseinrichtung zum Beaufschlagen der Spule mit einem Strom und/oder einer Spannung auf. Dadurch kann das Ventil bzw. die Spule betätigt werden.

Die Elektromagnetventilanordnung weist des Weiteren eine Zustandsbestimmungseinrichtung auf, welche dazu konfiguriert ist, ein erfindungsgemäßes Verfahren auszuführen. Dabei kann auf alle hierin beschriebenen Ausführungen und Varianten zurückgegriffen werden.

Mittels der erfindungsgemäßen Elektromagnetventilanordnung können die weiter oben erwähnten Vorteile für eine Elektromagnetventilanordnung nutzbar gemacht werden.

Die Erfindung betrifft des Weiteren ein nichtflüchtiges computerlesbares Speichermedium, auf welchem Programmcode gespeichert ist, bei dessen Ausführung ein erfindungsgemäßes Verfahren ausgeführt wird. Bezüglich des erfindungsgemäßen Verfahrens kann auf alle hierin beschriebenen Ausführungen und Varianten zurückgegriffen werden.

Weitere Merkmale und Vorteile wird der Fachmann dem nachfolgend mit Bezug auf die beigefügte Zeichnung beschriebenen Ausführungsbeispiel entnehmen. Dabei zeigt:

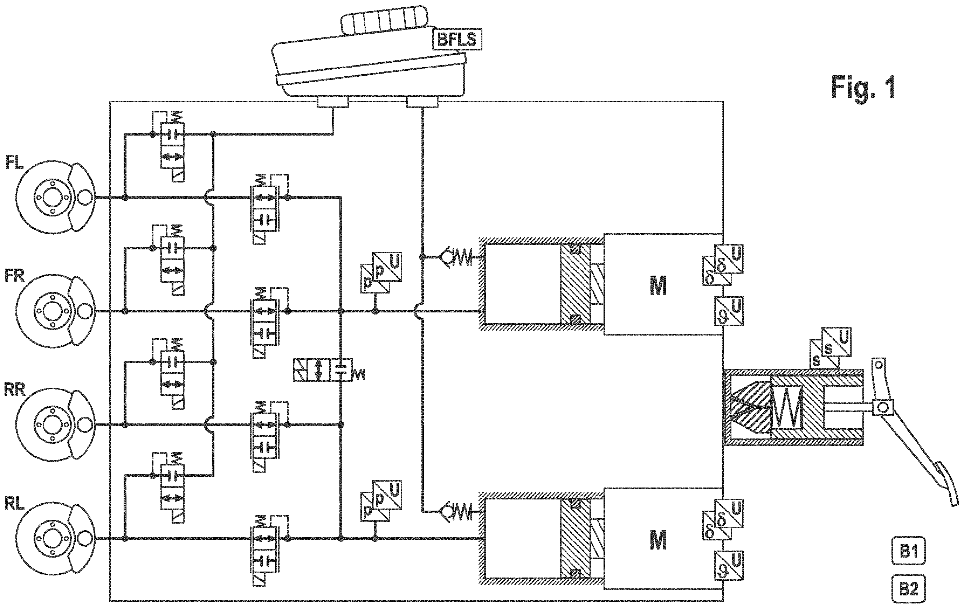

Fig. 1: einen hydraulischen Schaltplan eines Bremssystems, der nur mit Verwendung eines Einlassventils ohne Rückschlagventil funktioniert.

Durch die Erfindung wird, ein stromlos offenes Einlassventil ohne Rückschlagventil, jedoch mit Stößelöffnungskontrolle vorgesehen.

Um ein stromlos offenes Einlassventil ohne Rückschlagventil zu realisieren, wird erfindungsgemäß überwacht, ob der Stößel des Einlassventils nach Ausschalten der Spule in seine Ausgangsposition (offen) zurückfällt. Dies kann beispielsweise wie weiter oben beschrieben gemäß einer oder mehrerer der gezeigten Ausführungen geschehen. Beispielsweise kann dies jedoch auch wie nachfolgend beschrieben geschehen.

Durch eine Öffnungsbewegung des Stößels wird eine Spannung in der Spule induziert. Der Öffnungspunkt (oberer Anschlag des Stößels) ist dabei typischerweise durch eine Spannungsspitze deutlich zu erkennen.

Für den Fall, dass keine Öffnung detektiert wurde, beispielsweise weil der Stößel klemmt, kann das Auslassventil geschaltet werden, um den Druck im Bremssattel sicher abzubauen.

Die Vorteile eines Einlassventils ohne Rückschlagventil sind insbesondere die Einsparung weiterer Ventile, die dafür zuständig sind, den Druck im Rad einzusperren (z.B. beim Nachsaugen eines LAC), das Vermeiden eines sogenannten "Cross-Flows" sowie eine Kostenreduzierung durch den Wegfall des Rückschlagventils.

Ein beispielhafter hydraulischer Schaltplan für ein Bremssystem, welches nur mit Verwendung eines Einlassventils ohne Rückschlagventil funktioniert, ist in Fig. 1 dargestellt. Dieses wird hier nicht weiter beschrieben, sondern es sei vielmehr auf den klar verständlichen hydraulischen Schaltplan verwiesen.

## Patentansprüche

1. Verfahren zum Bestimmen eines Schaltzustands eines Einlassventils, welches mittels einer Spule betätigt wird, wobei das Verfahren folgende Schritte aufweist:
- zu einer Mehrzahl von Zeitpunkten, welche mit einem vorgegebenen Zeitabstand aufeinander folgen, jeweiliges Ermitteln eines durch die Spule fließenden Stroms und einer an der Spule anliegenden Spannung,
- Berechnen einer Induktivitätsgröße der Spule basierend auf den Strömen, der Spannung und dem Zeitabstand, und
- Bestimmen des Schaltzustands basierend auf der Induktivitätsgröße, wobei dadurch überwacht wird, ob ein Stößel des Einlassventils nach Ausschalten der Spule in seine Ausgangsposition zurückfällt, um ein stromlos offenes Einlassventil ohne Rückschlagventil zu realisieren.

2. Verfahren nach Anspruch 1,
- wobei aus einer Änderung des Schaltzustands ein Schalten des Einlassventils erkannt wird.

3. Verfahren nach einem der vorhergehenden Ansprüche,
- wobei ein Schaltzustand des Einlassventils (10) ferner durch Erkennen einer Spannungsspitze überwacht wird und/oder
- wobei aus einem Testsignal der Schaltzustand des Einlassventils erkannt wird.

4. Verfahren nach einem der vorhergehenden Ansprüche,
- wobei die Spule mittels Pulsweitenmodulation angesteuert wird,
- wobei Strom und Spannung jeweils über eine Pulsweitenmodulationsperiode gemittelt werden.

5. Verfahren nach einem der vorhergehenden Ansprüche,
- welches kontinuierlich oder laufend wiederholt ausgeführt wird.

6. Verfahren nach einem der vorhergehenden Ansprüche,
- wobei die Induktivitätsgröße mit einem ersten Endwert und einem zweiten Endwert verglichen wird,
- wobei wenn die Induktivitätsgröße maximal einen vorbestimmten Abstand vom ersten Endwert hat ein erster Schaltzustand bestimmt wird, und
- wobei wenn die Induktivitätsgröße maximal einen vorbestimmten Abstand vom zweiten Endwert hat ein zweiter Schaltzustand bestimmt wird.

7. Verfahren nach Anspruch 6,
- wobei die Schaltzustände Endzustände des Einlassventils sind.

8. Elektromagnetventilanordnung, aufweisend
- ein stromlos offenes Einlassventil ohne Rückschlagventil,
- eine Spule zur Betätigung des Einlassventils,
- eine Steuerungseinrichtung zum Beaufschlagen der Spule mit einem Strom und/oder einer Spannung, und
- einer Zustandsbestimmungseinrichtung, welche dazu konfiguriert ist, ein Verfahren nach einem der vorhergehenden Ansprüche auszuführen.

## Claims

1. Method for determining a switching state of an inlet valve that is actuated by means of a coil, wherein the method comprises the following steps:
- respectively ascertaining a current flowing through the coil and a voltage applied to the coil at several times which follow one another with a prespecified time interval,
- calculating an inductance variable of the coil based on the currents, the voltage and the time interval, and
- determining the switching state based on the inductance variable, wherein as a result monitoring is performed as to whether a tappet of the inlet valve falls back to its starting position, after the coil is switched off, in order to implement a normally open inlet valve without a non-return valve.

2. Method according to Claim 1,
- wherein switching of the inlet valve is identified from a change in the switching state.

3. Method according to either of the preceding claims,
- wherein a switching state of the inlet valve (10) is further monitored by identifying a voltage peak and/or
- wherein the switching state of the inlet valve is identified from a test signal.

4. Method according to one of the preceding claims,
- wherein the coil is driven by means of pulse-width modulation,
- wherein current and voltage are each averaged over a pulse-width modulation period.

5. Method according to one of the preceding claims,
- which is executed continuously or continually repeatedly.

6. Method according to one of the preceding claims,
- wherein the inductance variable is compared with a first end value and a second end value,
- wherein a first switching state is determined if the inductance variable is at most at a predetermined distance from the first end value, and
- wherein a second switching state is determined if the inductance variable is at most at a predetermined distance from the second end value.

7. Method according to Claim 6,
- wherein the switching states are end states of the inlet valve.

8. Solenoid valve assembly, having
- a normally open inlet valve without a non-return valve,
- a coil for actuating the inlet valve,
- a control device for applying a current and/or a voltage to the coil, and
- a state determination device which is configured to execute a method according to one of the preceding claims.

## Revendications

1. Procédé de détermination d'un état de commutation d'une soupape d'admission qui est actionnée au moyen d'une bobine, le procédé comportant les étapes suivantes :
- à une pluralité d'instants, qui se succèdent avec un intervalle de temps spécifié, déterminer à chaque fois un courant circulant à travers la bobine et une tension appliquée sur la bobine,
- calculer une valeur d'inductance de la bobine sur la base des courants, de la tension et l'intervalle de temps, et
- déterminer l'état de commutation sur la base de la valeur d'inductance, une surveillance étant ainsi effectuée quant à un retour d'un poussoir de la soupape d'admission à sa position initiale après la désactivation de la bobine, afin de réaliser une soupape d'admission ouverte hors tension sans soupape anti-retour.

2. Procédé selon la revendication 1,
- la commutation de la soupape d'admission étant détectée à partir d'un changement d'état de commutation.

3. Procédé selon l'une des revendications précédentes,
- un état de commutation de la soupape d'admission (10) étant également surveillé par détection d'un pic de tension et/ou
- l'état de commutation de la soupape d'admission étant détecté à partir d'un signal de test.

4. Procédé selon l'une des revendications précédentes,
- la bobine étant commandée au moyen d'une modulation de largeur d'impulsion,
- le courant et la tension étant chacun moyennés sur une période de modulation de largeur d'impulsion.

5. Procédé selon l'une des revendications précédentes,
- lequel est mis en oeuvre en continu ou de manière répétée en permanence.

6. Procédé selon l'une des revendications précédentes,
- la valeur d'inductance étant comparée à une première valeur finale et à une deuxième valeur finale,
- un premier état de commutation étant déterminé lorsque la valeur d'inductance est au maximum à une distance prédéterminée de la première valeur finale, et
- un deuxième état de commutation étant déterminé lorsque la valeur d'inductance est au maximum à une distance prédéterminée de la deuxième valeur finale.

7. Procédé selon la revendication 6,
- les états de commutation étant des états finaux de la soupape d'admission.

8. Ensemble de soupape électromagnétique comportant
- une soupape d'admission ouverte hors tension sans soupape anti-retour,
- une bobine destinée à actionner la soupape d'admission,
- un module de commande destiné à appliquer un courant et/ou une tension sur la bobine, et
- un module de détermination d'état qui est configuré pour mettre en oeuvre un procédé selon l'une des revendications précédentes.
